# EUROPÄISCHE PATENTSCHRIFT

(11) **EP 0 928 343 B1**
(45) Veröffentlichungstag und Bekanntmachung des Hinweises auf die Patenterteilung: **02.05.2001**
(21) Anmeldenummer: 97938854.3
(22) Anmeldetag: 23.07.1997
(51) Int. Cl.: C23C 14/16

(54) **VERFAHREN ZUR BESCHICHTUNG VON MESSING MIT HARTEN UND BUNTEN SCHICHTEN**
PROCESS FOR COATING BRASS WITH HARD, MULTICOLORED LAYERS
PROCEDE POUR REVETIR DU LAITON AVEC DES COUCHES DURES MULTICOLORES

(30) Priorität: 23.07.1996 DE 19629728
(43) Veröffentlichungstag der Anmeldung: 14.07.1999
(73) Patentinhaber: HAUZER TECHNO COATING EUROPE BV, 5902 RB Venlo (NL)
(72) Erfinder: MÜNZ, Wolf-Dieter, Sheffield S7 1SL (GB)
(74) Vertreter: Manitz, Finsterwald & Partner
(86) Internationale Anmeldenummer: EP9703996
(87) Internationale Veröffentlichungsnummer: WO9803694

(56) Entgegenhaltungen:
- DE-B- 1 148 838
- PATENT ABSTRACTS OF JAPAN vol. 096, no. 009, 30.September 1996 & JP 08 120481 A (NIPPON SHINKINZOKU KAKO KK;CITIZEN WATCH CO LTD), 14.Mai 1996,
- PATENT ABSTRACTS OF JAPAN vol. 013, no. 208 (C-596), 16.Mai 1989 & JP 01 025969 A (SEIKO EPSON CORP), 27.Januar 1989,

## Beschreibung

Die direkte Beschichtung von Messing mit Hilfe der PVD-Technologie stößt auf allseits bekannte Schwierigkeiten. Während der Beschichtung erwärmt sich das Grundmaterial. Als Folge des bekanntermaßen hohen Dampfdruckes von Zink (0,2 x 10⁻³ mbar bei 250°C) beginnt Zn mit zunehmender Temperatur zur verdampfen, was offenbar einer ausreichenden Haftfestigkeit der kondensierenden Schicht entgegenwirkt. Schlechte Haftfestigkeit und Verunreinigung der kondensierenden Schicht mit Zn und damit verbundene schlechte Korrosionseigenschaften der Hartstoffschicht sind die Folge. Aus diesem Grunde werden bisher die zu beschichtenden Teile mit galvanischen Verfahren metallisiert, die das Verdampfen von Zn aus dem Grundmaterial verhindern und darüber hinaus aufgrund ihrer eigenen chemischen Eigenschaften das Korrosionsverhalten von Messing verbessern helfen. Galvanische Schichtfolgen wie Cu/Ni/Cr, Cu/Ni, Ni/Cr, Ni oder Ni/NiPd sind bekannt und in der industriellen Praxis angewandt. Es ist auch bekannt, derartige vormetallisierte Teile mit hartem goldfarbenen TiN, messingfarbenem ZrN oder schwarzem TiAlN oder amorphem Metall-Kohlenstoffschichten mittels PVD-Verfahren zu veredeln.

Aus der JP-A-08 120 481 ist eine nickelfreie dekorative Schicht bekannt, die auf aus Messing hergestelltes Grundmaterial aufgebracht ist. Eine erste Schicht besteht dabei aus Kupfer oder einer Kupferlegierung mit einer Dicke von ≥ 1µm. Auf diese erste Schicht ist eine weitere Schicht aufgebracht, die aus TiN bestehen kann und eine Dicke von 0,1 bis 10 µm besitzt. Auf diese Schicht folgt eine Schicht aus Pd, Rh, Pt, Au, eine nickelfreien Legierung von Au oder TiNCO. Nach einem erwähnten Beispiel bezüglich des Beschichtungsverfahrens wird angegeben, daß eine Schicht von Sn, Cu und Pd bei einem Druck von 10⁻³ Torr abgeschieden wird. Darauf wird eine 5 µm dicke Schicht aus TiN aufgebracht, die aus Ti und N₂ besteht.

Aus JP-A-01 025 959 ist ein Verfahren zum Beschichten eines polierten Messing-Uhrengehäuses mit einer Kupferschicht bekannt. Auf diese Kupferschicht folgt eine Schicht aus Nickel, eine Schicht aus Pd oder Rh und eine Schicht aus TiN. Die Kupferschicht und die Nickelschicht werden durch Elektrolyse oder stromlos aufgebracht, und die Schicht aus TiN wird durch Ionenplattierung gebildet.

Aus der DE-P-1 148 838 ist ein Verfahren zum Herstellen einer Kugelschreiberminenspitze bekannt, bei dem die Oberfläche des Kugelbettes mit zumindest einer metallischen Schicht durch kathodisches Sputtern beschichtet wird. Als Beschichtungsmaterialien werden speziell Sn und Cu angegeben, wobei beide Metalle gleichzeitig abgeschieden werden können, um eine Bronzeauskleidung zu schaffen.

Ziel der Erfindung ist es, galvanische Beschichtungen komplett durch vakuumtechnisch hergestellte nickelfreie Beschichtungen zu ersetzen.

Gelöst wird diese Aufgabe insbesondere durch die Merkmale des Patentanspruchs 1.

Dabei werden die bekannten Verfahren von Magnetron-Kathodenzerstäubung und der kathodischem Bogenentladung benutzt. Zur Herstellung bunter Farbeffekte wird zusätzlich das Verfahren der Plasma-Oxidation und der naßchemischen anodischen Oxidation benutzt.

Die Erfindung umfaßt zwei sich ergänzende Aspekte, die wie folgt zu definieren sind:
1. Die Schaffung einer PVD beschichtbaren Ni-freien PVD-Grundmetallisierung.
   Diese Grundmetallisierung soll dazu dienen, die Diffusion von Zn während der eigentlichen PVD-Beschichtung soweit einzudämmen, daß haftfeste PVD beschichtbare Metallbeläge auf den Messingteilen entstehen. Dieses Ziel wird durch eine erste Beschichtung (PVD) mit Kupfer bzw. mit einer geeigneten Kupferlegierung erreicht. Zur Erzielung ausreichender Korrosionsbeständigkeit wird eine Schicht aus Niob oder Tantal auf die Kupfer- bzw. Kupferlegierungsschicht abgeschieden.
2. Um dekorative Effekte zu erzielen, kann die Grundschicht in bekannter Weise mit hartem goldfarbenen TiN, messingfarbenem ZrN oder schwarzem TiAlN bzw. Kohlenstoffschichten beschichtet werden. Eine weitere Möglichkeit besteht darin, das korrosionsbeständige Nb bzw. Ta entweder mittels Plasmaoxidation in vacuo oder naßchemisch anodisch zu oxidieren. Dadurch entstehen Oxidschichten mit auffallend bunten metallisch erscheinenden Farben. Die Farbeffekte werden durch Interferenzeffekte des einfallenden Lichtes erzeugt. Die Dicke dieser Schichten liegt zwischen 20 und 500 nm. Der Farbton wird durch die Oxidschichtdicke und die spezifischen Eigenschaften des zu oxidierenden Materials nämlich Nb oder Ta bestimmt. Um diese verschleiß- und damit farbempfindliche Schicht vor Abrieb zu schützen, ist es angebracht die farbgebende Oxidschicht mit einer 0,5 bis 2 µm dicken farbneutralen transparenten SiO₂- oder Al₂O₃-Schicht zu schützen.

Alle Schichten können mittels Kathodenzerstäubung, besonders vorteilhaft mittels Unbalanced-Magnetron-Sputtering oder mittels kathodischer Bogenentladungsverdampfung hergestellt werden. Zur Erstellung geeigneter Haftfestigkeiten ist es vorteilhaft, die Messingoberfläche entweder mit Nb oder Ta Metallionen zu reinigen bzw. zu implementieren (ABS-Verfahren/1/), und erst dann mit der eigentlichen Beschichtung zu beginnen. Dieser in vacuo durchgeführte Reinigungsvorgang soll bei entsprechend niedrigen Temperaturen beginnen, nämlich schon bei ungefähr 120°C. In der Folge ist darauf zu achten, daß während der Nb- oder Ta-Metallionen-Ätz-behandlung, die unter einer negativen Vorspannung von 600 bis 1200 V und in einer Argonatmosphäre von 0 bis 5 x 10⁻⁴ mbar stattfindet, eine Grenztemperatur der zu beschichtenden Substrate von 200°C nicht überschritten wird. Um dies zu erreichen, ist es vorteilhaft, den Ätzprozeß im Intervallbetrieb durchzuführen. Neuerdings stehen auch geeignete Impulsgeneratoren zur Verfügung. Bei der Beschichtung mit Cu und Nb oder Ta soll eine Substrattemperatur von 200 bis 380°C nicht überschritten werden. Es hat sich als besonders vorteilhaft erwiesen, wenn die Substrattemperatur im Bereich von 200 bis 250°C gehalten wird. Dies kann durch Optimierung der Beschichtungsparameter erreicht werden.

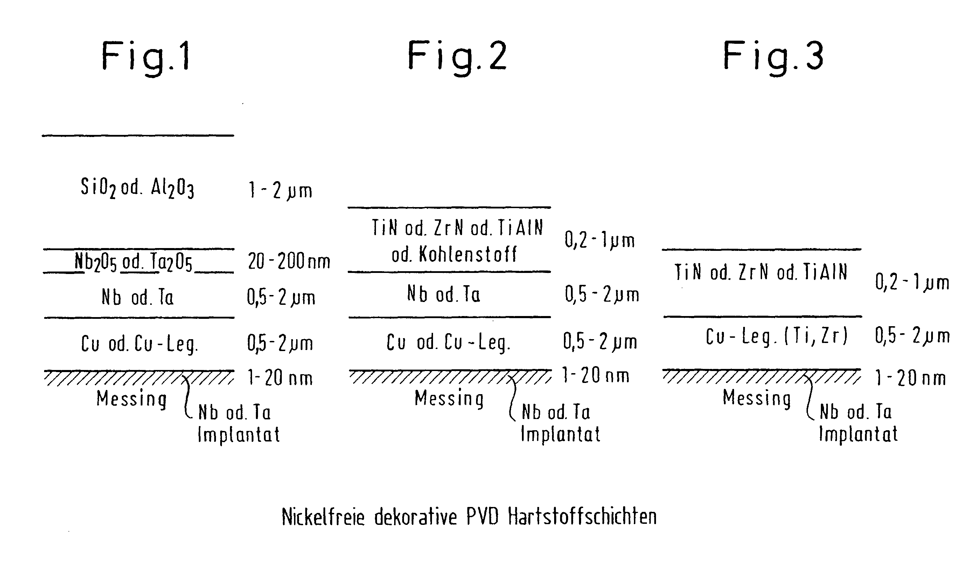

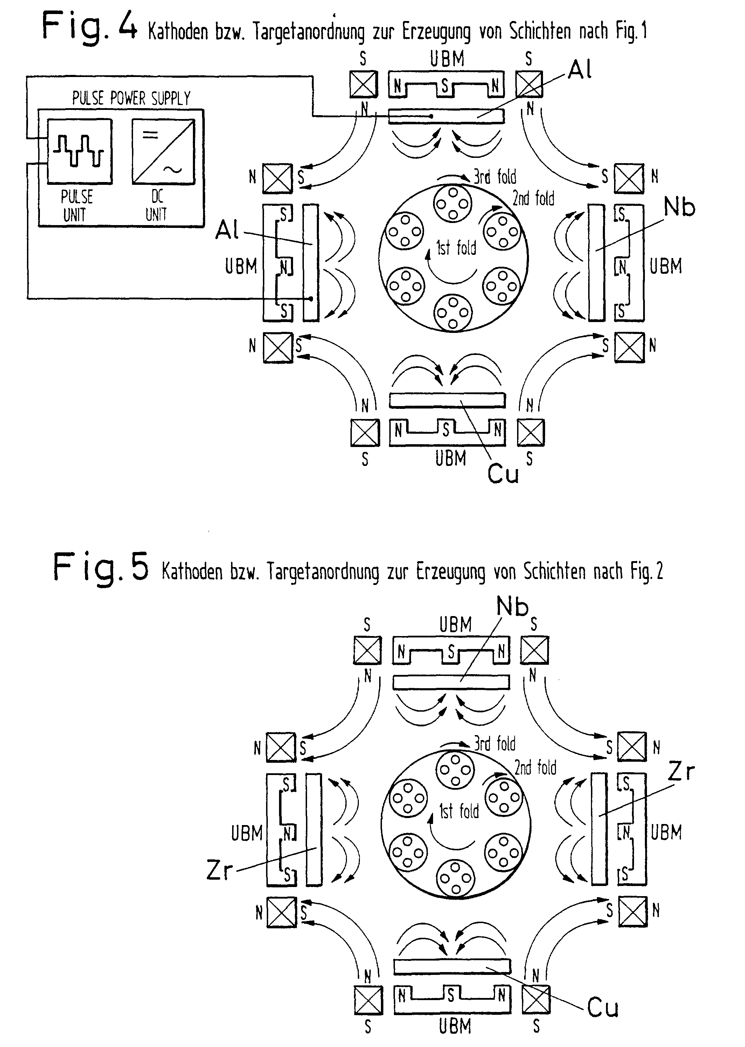

Eine erfindungsgemäße Schichtfolge ist in Fig. 1 dargestellt. Dabei handelt es sich um eine "bunte" Schicht, deren Farbe durch die Dicke der Nb₂O₅- oder Ta₂O₅-Schicht vorgegeben ist.

Eine vereinfachte Schichtfolge mit herkömmlich dekorativen oder tribologisch wirksamen Schichten wie TiN, ZrN, TiAlN oder Kohlenstoff ist in Fig. 2 angegeben. Bei optimierter Cu (oder Cu-Legierung) und Nb/Ta Vorbeschichtung kann die Beschichtung mit bekannten Hartstoffschichten im Temperaturbereich zwischen 250 und 350°C erfolgen. Dabei ist es primär unerheblich, ob die Beschichtung mittels Magnetron-Kathoden-zerstäubung oder kathodischer Bogenentladung erfolgt. Die in Fig. 1 eingezeichnete Nb oder Ta Implantatschicht verbessert das Reinigungsätzen beträchtlich. Trotzdem sei erwähnt, daß unter besonders günstigen Restvakuum-Verhältnissen ein Reinigungsätzen mit inerten Ar-Ionen ebenfalls ausreichenden Erfolg bewerkstelligen kann.

Die oben erwähnten Cu-Legierungen bestehen im besonderen aus handelsüblichem Cu-Al, Cu-Al-Fe Legierungen, die farblich auf die Farbe des Messings eingestellt werden können. Darüber hinaus erscheint eine Cu-Nb oder Cu-Ta Legierung ebenso vorteilhaft.

Diese können durch simultane Beschichtung unter Ausnutzung der vorhandenen Cu bzw. Nb oder Ta Targets hergestellt werden. Das Simultan-Verfahren erscheint besonders interessant und wirtschaftlich, weil teure Legierungstargets aus diesen Materialien mit sehr unterschiedlichen Schmelzpunkten vermieden werden können. Dabei kann die Simultanbeschichtung entweder mit Magnetron-Kathodenzerstäubungsquellen oder mit kathodischen Bogenentladungsverdampfern oder kombiniert erfolgen, so daß der Kupferanteil von der Magnetron-Kathode und der Nb- oder Ta-Anteil von der Bogenentladungsquelle stammt. Bei derartiger Kombination wird die Ionisierung mit Nb oder Ta erhöht bei relativ niedrigerer "Droplet"-Erzeugung (Makropartikel) wie es sonst der Bogenentladungsverdampfung zu eigen ist. Dies ist auf den hohen Schmelzpunkt von Nb und Ta zurückzuführen /2/. Das relativ dazu niedrigschmelzende Kupfer wird daher vorteilhaft mit der Magnetron-Quelle verdampft. Es hat sich als besonders vorteilhaft erwiesen, den Nb- oder Ta-Gehalt graduiert, d.h. mit zunehmender Kupferlegierungsschichtdicke ansteigend zu gestalten. Dadurch wird in erster Linie das Substrattemperaturproblem entschärft, und es werden Kosten von teurem Nb oder Ta-Material gespart und es wird dennoch eine ausgezeichnete Korrosionsbeständigkeit erzielt. Die graduierte Nb bzw. Ta Verteilung wird erzielt, indem die Zerstäubungsleistung am Kupfer konstant gehalten wird und die Verdampferleistung an der Nb- oder Ta-Quelle kontinuierlich gesteigert wird.

Parallel zu den Untersuchungen insbesondere mit graduiertem Nb oder Ta, hat sich überraschenderweise gezeigt, daß man ähnlich positive Trends erzielen kann, wenn in die Kupferlegierung entweder Ti oder Zr, bevorzugt mit der Bogenentladungsquelle, eingebaut wird. Es ist sogar möglich, eine "Sparvariante" zu der in Fig. 2 wiedergegebenen Schichtfolge herzustellen.

Fig. 3 zeigt eine Ti- oder Zr-haltige Kupferlegierung in einer Schichtfolge ohne Nb oder Ta. Es hat sich herausgestellt, daß diese Sparvariante besonders günstiges Korrosionsverhalten zeigt, wenn man Zr als Legierungszusatz verwendet. Zr zeigt nämlich eine wesentlich geringere Droplet-Bildung im Vergleich zu Ti/2/, so daß lokale Korrosionsdefekte reduziert werden können.

Die Abscheidung der transparenten, verschleißhemmenden SiO₂- oder Al₂O₃-Schichten erfolgt bevorzugt mittels reaktiver Magnetronzerstäbung unter Verwendung von Impulsgeneratoren /3/.

Besonders vorteilhaft hat sich erwiesen, wenn jeweils zwei Kathoden im Impulsbetrieb gegeneinander geschaltet werden (TWIN-Anordnung) um so hohe Beschichtungswerte zu erzielen.

Die hier erwähnten Beschichtungsprozesse umfassen Prozeßstufen wie Metall-Ionen-Ätzen, Ar-Glimm-Ätzen, Magnetron-Kathodenzerstäubung und kathodisches Bogenentladungsverdampfen. Sämtliche dieser Prozeßschritte können in der sogenannten Arc-Bond-Sputter-Technik (ABS) sequentiell oder simultan ausgeführt werden /1/.
Dazu stehen Kathoden-Konstruktionen zur Verfügung, die alternativ als Magnetron- oder als Bogenentladungskathoden verwendet werden können. Es ist deshalb empfehlenswert, die einzelnen Beschichtungsschritte in Multitärget-Beschichtungsanlagen, d.h. in Prozeßfolgen ohne Unterbrechung des Vakuums auszuführen.

Fig. 4 zeigt z.B. ein Anlagenkonzept zur Herstellung "bunter" Schichten. Aufgrund der hohen Zerstäubungseffizienz von Kupfer mit 2,35 Cu-Atomen pro einfallendem Ar-Ion (Vergleich: 0,51 Ti-Atome/Ar-Ion, 0,57 Ta-Atome/Ar-Ion, 0,6 Nb-Atome/Ar-Ion oder 0,65 Zr-Atome/Ar-Ion) /4/ genügt eine einzelne Magnetronkathode, um die relativ dicke Kupfer- bzw. Kupferlegierungsschicht abzuscheiden. Wie aus den Fig. 1 und 2 hervorgeht, sind die entsprechenden Korrosionsbarrieren aus Nb oder Ta dünner, d.h. die durch die Natur vorgegebene reduzierte Beschichtungsrate fällt weniger ins Gewicht, wenn man nur ein Nb- oder Ta-Target verwendet. Aus diesem Grunde ist es möglich, die restlichen zwei Kathodenplätze mit Si- oder Al-Targets zu besetzen, um diese z.B. in TWIN-Anordnung zu betreiben.

Fig. 5 zeigt schließlich eine Anlagenanordnung, die speziell geeignet ist für herkömmliche Dekorbeschichten, z.B. TiN, ZrN oder TiAlN auf MessingTeilen. Hier genügt ebenfalls ein Kupfer- oder Kupferlegierungs-Target, ein Nb oder Ta-Target. Die restlichen zwei Kathoden werden vornehmlich zur Herstellung der dekorativen Nitridschicht verwendet. Die Praxis zeigt, daß im reaktiven Beschichtungsbetrieb beträchtliche Reduzierungen der erzielbaren Beschichtungsrate auftreten (Faktor 3 bis 5 gegenüber nichtreaktivem Betrieb) /5/, so daß zwei Targets zur wahlweisen Herstellung von TiN, ZrN oder TiAlN-Dekorbeschichtungen als ausreichend erscheinen.

### Referenzen

/1/ W.-D. Münz, D. Schulze, F.J.M. Hauzer
   "A New Method for Hard Coatings: ABS™
   (arc bond sputtering)"
   Surf.Coat.Technol., 50 (1992) S. 169 - 178
/2/ W.-D. Münz, I. U. Smith, D.B. Lewis, S. Crease
   "Droplet Formation on Steel Substrates during Cathodic Steered Arc Metal Ion Etch Vaccum"
   Vol. 48/Nr. 5 (1997), S. 473 - 481
/3/ F. Fietzke, K. Goedicke, W. Hempel
   "The Deposition of Hard Crystalline Al₂O₃ Layers by Means of
   Pulsed Bipolar Magnetron Sputtering"
   Surf.Coat. Technol. 86 - 87 (1996), S. 657 - 663
/4/ J.L. Vossen, J.J. Cuomo,
   "Glow Discharge Sputter Deposition"
   Thin Film Process, J.L. Vossen and W. Kern, Ed., Academic
   Press, 1978, S. 12 - 73
/5/ W.D. Sproul,
   "High Rate Sputtering Process Control"
   Surf. Coat. Technol., Vol. 33, 1987, S. 73- 81

## Patentansprüche

1. Verfahren zur Beschichtung von Messing bzw. Teilen aus Messing, insbesondere Uhrengehäuse, Schreibgeräte, Brillengestelle, Schmuck, Türbeschläge, Badezimmerarmaturen und dergleichen mit bunten und harten Schichten unter Verwendung der PVD-Technologie (physical vapour deposition-technology) und unter Verwendung einer Grundmetallisierung, die ebenfalls nach der PVD-Technologie abgeschieden ist,
dadurch **gekennzeichnet**,
daß die Grundmetallisierung aus einer Kupferschicht bzw. einer zinkfreien Kupferlegierung und einer darauffolgenden Niob- oder Tantalschicht besteht.

2. Verfahren nach Anspruch 1,
dadurch **gekennzeichnet**,
daß die Schichtdicke der aufgebrachten Kupferschicht bzw. zinkfreien Kupferlegierung im Bereich von 0,1 bis 10 µm und die der Niob- bzw. Tantalschicht im Bereich von 0,2 bis 3 µm liegt.

3. Verfahren nach Anspruch 1 oder 2,
dadurch **gekennzeichnet**,
daß die Schichtdicke der aufgebrachten Kupferschicht bzw. zinkfreien Kupferlegierung 0,5 bis 3 µm und die Schichtdicke der Niob- bzw. Tantalschicht 0,2 bis 1 µm beträgt.

4. Verfahren nach einem der vorhergehenden Ansprüche,
dadurch **gekennzeichnet**,
daß die PVD-Abscheidung der Schichten mittels Magnetron-Kathodenzerstäubung erfolgt.

5. Verfahren nach einem der Ansprüche 1 bis 3,
dadurch **gekennzeichnet**,
daß die PVD-Abscheidung der Schichten mittels kathodischer Bogenentladung erfolgt.

6. Verfahren nach einem der Ansprüche 1 bis 3,
dadurch **gekennzeichnet**,
daß die PVD-Abscheidung der Kupferschicht bzw. der zinkfreien Kupferlegierung mittels Magnetron-Kathodenzerstäubung und die der Niob- bzw. Tantalschichten mittels kathodischer Bogenentladung erfolgt.

7. Verfahren nach Anspruch 1 und 4,
dadurch **gekennzeichnet**,
daß zur Abscheidung der Kupferlegierung ein Target aus einer bestimmten Kupferlegierung verwendet wird, die im wesentlichen die gleiche Legierungszusammensetzung aufweist wie die abgeschiedene Schicht.

8. Verfahren nach Anspruch 7,
dadurch **gekennzeichnet**,
daß die Kupferlegierung aus Kupfer und Aluminium besteht.

9. Verfahren nach Anspruch 7,
dadurch **gekennzeichnet**,
daß die Kupferlegierung aus Kupfer, Aluminium und Eisen besteht.

10. Verfahren nach Anspruch 9,
dadurch **gekennzeichnet**,
daß die Kupferlegierung aus Kupfer, 6 bis 10 Gew.% Al und 1 bis 5 Gew.% Fe besteht.

11. Verfahren nach den Ansprüchen 1 und 4,
dadurch **gekennzeichnet**,
daß die Kupferlegierung aus Kupfer und Nb oder Ta durch simultane Magnetron-Kathodenzerstäubung erzeugt wird.

12. Verfahren nach den Ansprüchen 1 und 4,
dadurch **gekennzeichnet**,
daß der Nb- bzw. Ta-Gehalt der Kupferlegierung 5 bis 6 at% beträgt.

13. Verfahren nach Anspruch 12,
dadurch **gekennzeichnet**,
daß der Nb- bzw. Ta-Gehalt zwischen 25 und 45 at% liegt.

14. Verfahren nach den Ansprüchen 1, 6 und 12,
dadurch **gekennzeichnet**,
daß die Herstellung der Kupferlegierung bestehend aus Cu und Nb oder Ta durch simultane Abscheidung des Kupfers durch Magnetron-Kathodenzerstäubung erfolgt und Nb oder Ta durch kathodische Bogenentladung abgeschieden wird.

15. Verfahren nach Anspruch 11 und 14,
dadurch **gekennzeichnet**,
daß die Verteilung von Nb oder Ta in der Kupferlegierung graduiert gestaltet wird, d.h. daß der Gehalt von Nb oder Ta in der Kupferlegierung mit zunehmender Schichtdicke ansteigt.

16. Verfahren nach Anspruch 15,
dadurch **gekennzeichnet**,
daß der Gehalt an Nb oder Ta bei niedrigen Schichtdicken (kleiner 30 % der Grundschichtdicke der Kupferlegierung) zwischen 0 und 10 at% Nb oder Ta liegt und daß der Nb- oder Ta-Gehalt bis zur vollen Schichtdicke der Kupferlegierung auf 25 bis 45 at% ansteigt.

17. Verfahren nach Anspruch 1,
dadurch **gekennzeichnet**,
daß vor Abscheidung der Kupfer- bzw. Kupferlegierungsbeschichtung die Messingteile einer Metall-Ionen-Vorbehandlung unterzogen werden, dergestalt, daß Nb- bzw. Ta-Ionen, die in einer kathodischen Bogenentladung erzeugt werden, mit hoher Energie, typischerweise mit 700 bis 1200 eV, mit einer Einwirkzeit von 2 bis 10 min. auf die Teile beschleunigt werden, um dort eine Verankerungsschicht herzustellen.

18. Verfahren nach Anspruch 1,
dadurch **gekennzeichnet**,
daß auf die Grundmetallisierung eine dekorative harte Schicht aus TiN, ZrN, TiCN, ZrCN, TiAlN, TiAlCN oder amorphem Metall-Kohlenstoff abgeschieden wird, und zwar mit einer Schichtdicke von etwa 0,1 bis 3 µm.

19. Verfahren nach Anspruch 1 und 2,
dadurch **gekennzeichnet**,
daß die dekorativen Schichten aus TiN, ZrN, TiCN, ZrCN, TiAlN bzw. TiAlCN mittels Magnetron-Kathodenzerstäubung abgeschieden werden.

20. Verfahren nach Anspruch 1 und 18,
dadurch **gekennzeichnet**,
daß die dekorativen Schichten von TiN, ZrN, TiCN, ZrCN, TiAlN bzw. TiAlCN mittels kathodischer Bogenentladung abgeschieden werden.

21. Verfahren nach einem der vorhergehenden Ansprüche,
dadurch **gekennzeichnet**,
daß im Falle einer Verwendung einer harten dekorativen Schicht aus TiN, ZrN, TiCN, ZrCN die dazu verwendeten Targets alternativ zur Herstellung einer Kupferlegierung benutzt werden unter Anwendung einer simultanen Abscheidung von Kupfer und Ti oder Zr.

22. Verfahren nach Anspruch 21,
dadurch **gekennzeichnet**,
daß für die Abscheidung von Ti oder Zr die gleichen Prinzipien verwendet werden wie für die Abscheidung von Nb oder Ta in einem oder mehreren der Ansprüche 13 bis 19.

23. Verfahren nach Anspruch 21,
dadurch **gekennzeichnet**,
daß auf die Metallisierung mit Nb oder Ta vollständig verzichtet wird und die dekorativen Schichten aus TiN, ZrN, TiCN, ZrCN, TiAlN, TiAlCN und amorphem Metall-Kohlenstoff direkt auf die mit Ti oder Zr angereicherte Kupferlegierung abgeschieden werden.

24. Verfahren nach Anspruch 1,
dadurch **gekennzeichnet**,
daß die Grundmetallisierung einer anodischen Oxidation in verdünnten, wässrigen, sauren Elektrolyten unterzogen wird, um bunte Interferenzschichten aus Nb₂O₅ oder Ta₂O₅ zu erzeugen.

25. Verfahren nach Anspruch 1,
dadurch **gekennzeichnet**,
daß die Grundmetallisierung einer Plasma-Oxidation in einer sauerstoffhaltigen Atmosphäre unterworfen wird.

26. Verfahren nach einem der Ansprüche 1, 24 oder 25,
dadurch **gekennzeichnet**,
daß die bunte Oxidschicht bestehend aus Nb₂O₅ oder Ta₂O₅ mit einer abriebfesten Oxidschicht aus SiO₂ oder Al₂O₃ überzogen wird.

27. Verfahren nach einem der Ansprüche 1, 24, 25 oder 26,
dadurch **gekennzeichnet**,
daß die Dicke der SiO₂- oder Al₂O₃-Schicht so bemessen ist, daß das Erscheinungsbild der bunten Nb₂O₅- oder Ta₂O₅-Schichten nicht gestört wird.

28. Verfahren nach Anspruch 27,
dadurch **gekennzeichnet**,
daß die Schichtdicke von SiO₂ bzw. Al₂O₃ etwa zwischen 0,5 und 2 µm liegt.

29. Verfahren nach einem der Ansprüche 1, 17 oder 18,
dadurch **gekennzeichnet**,
daß alle PVD-Prozeßschritte in einer Multitarget-Beschichtungsanlage stattfinden, die mit entsprechenden Targets ausgerüstet ist, um verschleißfeste und korrosionsbeständige dekorative Schichten auf Messing in einem einzigen Vakuumbeschichtungsvorgang durchführen zu können.

30. Verfahren nach einem oder mehreren der Ansprüche 1, 17, 25 oder 26,
dadurch **gekennzeichnet**,
daß alle PVD-Prozeßschritte in einer Multitarget-Beschichtungsanlage stattfinden, die mit entsprechenden Targets ausgerüstet ist, um bunte verschleißfeste korrosionsbeständige dekorative Schichten auf Messing in einem einzigen Vakuumbeschichtungsvorgang durchführen zu können.

31. Verfahren nach den Ansprüchen 1 und 17,
dadurch **gekennzeichnet**,
daß der Metall-Ionen-Ätzprozeß schon bei einer Substrattemperatur von 120°C beginnt und daß eine Substrattemperatur von 200°C nicht überschritten wird.

32. Verfahren nach Anspruch 1,
dadurch **gekennzeichnet**,
daß die Beschichtung mit Kupfer oder mit einer Kupferlegierung bzw. mit Niob oder Tantal im Temperaturbereich von 200 bis 250°C durchgeführt wird.

33. Verfahren nach den Ansprüchen 1 und 18,
dadurch **gekennzeichnet**,
daß bei der Beschichtung mit TiN, ZrN, TiAlN, TiCN, ZrCN oder TiAlCN die Beschichtungstemperatur im Bereich von 200 bis 380°C liegt.

## Claims

1. Method of coating brass or parts of brass, in particular timepiece housings, writing utensils, spectacle frames, jewelry, door fittings, bathroom armatures and the like, with colored and hard layers using PVD technology (physical vapor deposition technology) and using a base metallization which is likewise deposited in accordance with PVD technology, characterized in that the base metallization consists of a copper layer or of a zinc-free copper alloy and a subsequent niobium or tantalum layer.

2. Method in accordance with claim 1, characterized in that the layer thickness of the copper layer or zinc-free copper alloy that is applied lies in the range from 0.1 to 10 µm and that of the niobium or tantalum layer in the range from 0.2 to 3 µm.

3. Method in accordance with claim 1 or claim 2, characterized in that the layer thickness of the copper layer or zinc-free copper alloy that is applied amounts to 0.5 to 3 µm and the layer thickness of the niobium or tantalum layer amounts to 0.2 to 1 µm.

4. Method in accordance with one of the preceding claims, characterized in that the PVD deposition of the layers takes place by means of magnetron cathode sputtering.

5. Method in accordance with one of the claims 1 to 3, characterized in that the PVD deposition of the layers takes place by means of cathodic arc discharge.

6. Method in accordance with one of the claims 1 to 3, characterized in that the PVD deposition of the copper layer or of the zinc-free copper alloy takes place by means of magnetron cathode sputtering, and the deposition of the niobium or tantalum layers takes place by means of cathodic arc discharge.

7. Method in accordance with claims 1 and 4, characterized in that a target of a specific copper alloy is used for the deposition of the copper alloy and has substantially the same alloy composition as the deposited layer.

8. Method in accordance with claim 7, characterized in that the copper alloy consists of copper and aluminum.

9. Method in accordance with claim 7, characterized in that the copper alloy consists of copper, aluminum and iron.

10. Method in accordance with claim 9, characterized in that the copper alloy consists of copper, 6 to 10 % by weight Al and 1 to 5 % by weight Fe.

11. Method in accordance with the claims 1 and 4, characterized in that the copper alloy is produced from copper and Nb or Ta by means of simultaneous magnetron cathode sputtering.

12. Method in accordance with the claims 1 and 4, characterized in that the Nb and/or Ta content of the copper alloy amounts to 5 to 6 at%.

13. Method in accordance with claim 12, characterized in that the Nb and/or Ta content lies between 25 and 45 at%.

14. Method in accordance with the claims 1, 6 and 12, characterized in that the manufacture of the copper alloy consisting of Cu and Nb or Ta takes place by simultaneous deposition of the copper by magnetron cathode sputtering, and Nb or Ta is deposited by cathodic arc discharge.

15. Method in accordance with claims 11 and 14, characterized in that the distribution of Nb or Ta in the copper alloy is made graduated, i.e. that the content of Nb or Ta in the copper alloy increases with increasing layer thickness.

16. Method in accordance with claim 15, characterized in that the content of Nb or Ta with low layer thicknesses (smaller than 30 % of the base layer thickness of the copper alloy) lies between 0 and 10 at% Nb or Ta and in that the Nb or Ta content increases to 25 to 45 at% up to the full layer thickness of the copper alloy.

17. Method in accordance with claim 1, characterized in that the brass parts are subjected to a metal-ion pre-treatment prior to deposition of the copper or copper alloy coating in such a form that Nb or Ta ions, which are produced in a cathodic arc discharge, are accelerated with high energy, typically with 700 to 1200 eV, onto the parts with a time of action of 2 to 10 minutes in order to produce an anchoring layer there.

18. Method in accordance with claim 1, characterized in that a decorative, hard layer of TiN, ZrN, TiCN, ZrCN, TiAlN, TiAlCN or amorphous metal carbon is deposited onto the base metallization, and indeed with a layer thickness of approximately 0.1 to 3 µm.

19. Method in accordance with claims 1 and 2, characterized in that the decorative layers of TiN, ZrN, TiCN, ZrCN, TiAlN or TiAlCN are deposited by magnetron cathode sputtering.

20. Method in accordance with claims 1 and 18, characterized in that the decorative layers of TiN, ZrN, TiCN, ZrCN, TiAlN or TiAlCN are deposited by means of cathodic arc discharge.

21. Method in accordance with one of the preceding claims, characterized in that when using a hard, decorative layer of TiN, ZrN, TiCN, ZrCN the targets used for this purpose are alternatively used for the production of a copper alloy using a simultaneous deposition of copper and Ti or Zr.

22. Method in accordance with claim 21, characterized in that for the deposition of Ti or Zr the same principles are used as for the deposition of Nb or Ta in one or more of the claims 13 to 19.

23. Method in accordance with claim 21, characterized in that the metallization with Nb or Ta is dispensed with entirely and the decorative layers of TiN, ZrN, TiCN, ZrCN, TiAlN, TiAlCN and amorphous metal carbon are deposited directly onto the copper alloy enriched with Ti or Zr.

24. Method in accordance with claim 1, characterized in that the base metallization is subjected to an anodic oxidation in diluted, aqueous, acid electrolytes in order to produce colored interference layers of Nb₂O₅ or Ta₂O₅.

25. Method in accordance with claim 1, characterized in that the base metallization is subjected to a plasma oxidation in an oxygen-containing atmosphere.

26. Method in accordance with one of the claims 1, 24 or 26, characterized in that the colored oxide layer consisting of Nb₂O₅ or Ta₂O₅ is coated with an abrasion-resistant oxide layer of SiO₂ or Al₂O₃.

27. Method in accordance with one of the claims 1, 24, 25 or 26, characterized in that the thickness of the SiO₂ or Al₂O₃ layer is so dimensioned that the appearance of the colored Nb₂O₅ or Ta₂O₅ layers is not disturbed.

28. Method in accordance with claim 27, characterized in that the layer thickness of SiO₂ or Al₂O₃ lies approximately between 0.5 and 2 µm.

29. Method in accordance with one of the claims 1, 17 or 18, characterized in that all PVD process steps take place in a multi-target coating plant, which is equipped with corresponding targets in order to be able to execute wear-resistant and corrosion-resistant decorative layers on brass in a single vacuum coating process.

30. Method in accordance with one or more of the claims 1, 17, 25 or 26, characterized in that all PVD process steps take place in a multi-target coating plant, which is equipped with corresponding targets in order to be able to execute colored, wear- and corrosion-resistant, decorative coating on brass in a single vacuum coating process.

31. Method in accordance with the claims 1 and 17, characterized in that the metal-ion etching process already starts at a substrate temperature of 120°C, and in that a substrate temperature of 200°C is not exceeded.

32. Method in accordance with claim 1, characterized in that the coating with copper or with a copper alloy or with niobium or tantalum is carried out in the temperature range from 200 to 250°C.

33. Method in accordance with the claims 1 and 18, characterized in that during the coating with TiN, ZrN, TiAlN, TiCN, ZrCN or TiAlCN the coating temperature lies in the range from 200 to 380°C.

## Revendications

1. Procédé pour revêtir du laiton ou des pièces en laiton, en particulier boîtiers de montre, stylos, montures de lunettes, bijouterie, ferrures de porte, robinetteries sanitaires et similaires avec des couches multicolores par application de la technologie PVD (physical vapour deposition-technology) et par application d'une métallisation de base déposée également selon la technologie PVD, caractérisé en ce que la métallisation de base est constituée par une couche de cuivre ou par un alliage de cuivre exempt de zinc, et par une couche de niobium ou de tantale successive.

2. Procédé selon la revendication 1, caractérisé en ce que l'épaisseur de la couche déposée de cuivre ou d'alliage de cuivre exempt de zinc est dans la plage de 0,1 à 10 µm et celle de la couche en niobium ou en tantale est dans la plage de 0,2 à 3 µm.

3. Procédé selon l'une ou l'autre des revendications 1 et 2, caractérisé en ce que l'épaisseur de la couche déposée de cuivre ou d'alliage de cuivre exempt de zinc est comprise entre 0,5 et 3 µm et celle de la couche en niobium ou en tantale est comprise entre 0,2 et 1 µm.

4. Procédé selon l'une quelconque des revendications précédentes, caractérisé en ce que la déposition des couches par technologie PVD s'effectue au moyen d'une pulvérisation cathodique par magnétron.

5. Procédé selon l'une quelconque des revendications 1 à 3, caractérisé en ce que la déposition des couches par la technologie PVD s'effectue au moyen d'une décharge d'un arc cathodique.

6. Procédé selon l'une quelconque des revendications 1 à 3, caractérisé en ce que la déposition par technologie PVD de la couche de cuivre ou d'alliage de cuivre exempt de zinc s'effectue au moyen de pulvérisation cathodique par magnétron et celle des couches en niobium ou en tantale s'effectue au moyen de décharge d'un arc cathodique.

7. Procédé selon les revendications 1 et 4, caractérisé en ce que pour la déposition de l'alliage de cuivre, on utilise une cible d'un certain alliage de cuivre qui présente sensiblement la même composition d'alliage que la couche déposée.

8. Procédé selon la revendication 7, caractérisé en ce que l'alliage de cuivre est constitué en cuivre et en aluminium.

9. Procédé selon la revendication 7, caractérisé en ce que l'alliage de cuivre est constitué en cuivre, en aluminium et en fer.

10. Procédé selon la revendication 9, caractérisé en ce que l'alliage de cuivre est constitué de cuivre, de 6 à 10 % en poids de Al, et de 1 à 5 % en poids de Fe.

11. Procédé selon les revendications 1 et 4, caractérisé en ce que l'alliage de cuivre constitué en cuivre et en Nb ou en Ta est réalisé par pulvérisation cathodique par magnétron simultanée.

12. Procédé selon les revendications 1 et 4, caractérisé en ce que la teneur en Nb ou en Ta de l'alliage de cuivre est de 5 à 6 atomes %.

13. Procédé selon la revendication 12, caractérisé en ce que la teneur en Nb ou en Ta est comprise entre 25 et 45 atomes %.

14. Procédé selon les revendications 1, 6 et 12, caractérisé en ce que la production de l'alliage de cuivre constitué en Cu et en Nb ou en Ta s'effectue par déposition simultanée du cuivre par pulvérisation cathodique par magnétron, et en ce que le Nb ou Ta est déposé par décharge d'un arc cathodique.

15. Procédé selon les revendications 11 et 14, caractérisé en ce que la répartition du Nb ou Ta dans l'alliage de cuivre est réalisée de façon graduée, c'est-à-dire que la teneur en Nb ou Ta dans l'alliage de cuivre augmente avec la croissance de l'épaisseur de la couche.

16. Procédé selon la revendication 15, caractérisé en ce que la teneur en Nb ou Ta dans des épaisseurs de couche faibles (inférieures à 30 % de l'épaisseur de couche de base de l'alliage de cuivre) est comprise entre 0 et 10 atomes % de Nb ou Ta, et en ce que la teneur en Nb ou Ta augmente à une valeur de 25 à 45 atomes % jusqu'à l'épaisseur de couche complète de l'alliage de cuivre.

17. Procédé selon la revendication 1, caractérisé en ce qu'avant déposition du revêtement de cuivre ou d'alliage de cuivre les pièces en laiton sont soumises à un traitement préalable au moyen d'ions métalliques, de telle sorte que des ions de Nb ou de Ta qui sont produits dans une décharge d'un arc cathodique sont accélérés en direction des pièces avec une énergie élevée, typiquement avec 700 à 1200 eV, et avec une durée d'action de 2 à 10 min, afin d'y produire une couche d'ancrage.

18. Procédé selon la revendication 1, caractérisé en ce que l'on dépose sur la métallisation de base une couche dure décorative en TiN, ZrN, TiCN, ZrCN, TiAlN, TiAlCN ou en carbure de métal amorphe, avec une épaisseur de couche d'environ 0,1 à 3 µm.

19. Procédé selon les revendications 1 et 2, caractérisé en ce que les couches décoratives en TiN, ZrN, TiCN, ZrCN, TiAlN ou en TiAlCN sont déposées au moyen de pulvérisation cathodique par magnétron.

20. Procédé selon les revendications 1 et 18, caractérisé en ce que les couches décoratives en TiN, ZrN, TiCN, ZrCN, TiAlN ou en TiAlCN sont déposées au moyen de décharge d'un arc cathodique.

21. Procédé selon l'une quelconque des revendications précédentes, caractérisé en ce que dans le cas d'une application de la couche dure décorative en TiN, ZrN, TiCN, ZrCN, les cibles utilisées à cet effet sont utilisées en variante pour produire un alliage de cuivre avec application d'une déposition simultanée de cuivre et de Ti ou Zr.

22. Procédé selon la revendication 21, caractérisé en ce que pour la déposition de Ti ou Zr, on applique les mêmes principes que pour la déposition de Nb ou Ta dans une ou plusieurs des revendications 13 à 19.

23. Procédé selon la revendication 21, caractérisé en ce que l'on renonce totalement à la métallisation avec du Nb ou Ta, et en ce que l'on dépose les couches décoratives en TiN, ZrN, TiCN, ZrCN, TiAlN, TiAlCN et en carbure de métal amorphe directement sur l'alliage de cuivre enrichi en Ti ou Zr.

24. Procédé selon la revendication 1, caractérisé en ce que la métallisation de base est soumise à une oxydation anodique dans des électrolytes dilués aqueux acides, pour produire des couches d'interférence multicolores en Nb₂O₅ ou en Ta₂O₅.

25. Procédé selon la revendication 1, caractérisé en ce que la métallisation de base est soumise à une oxydation par plasma dans une atmosphère contenant de l'oxygène.

26. Procédé selon l'une quelconque des revendications 1, 24 ou 25, caractérisé en ce que la couche d'oxyde multicolore constituée en Nb₂O₅ ou en Ta₂O₅ est revêtue avec une couche d'oxyde résistante à l'abrasion en SiO₂ ou Al₂O₃.

27. Procédé selon l'une quelconque des revendications 1, 24, 25 ou 26, caractérisé en ce que l'épaisseur de la couche en SiO₂ ou Al₂O₃ est choisie de telle sorte que l'aspect des couches multicolores en Nb₂O₅ ou Ta₂O₅ n'est pas perturbé.

28. Procédé selon la revendication 27, caractérisé en ce que l'épaisseur de couche en SiO₂ ou Al₂O₃ est comprise entre environ 0,5 et 2 µm.

29. Procédé selon l'une quelconque des revendications 1, 17 ou 18, caractérisé en ce que toutes les opérations du processus PVD s'effectuent dans une installation de revêtement multi-cibles qui est équipée de cibles correspondantes pour pouvoir réaliser des couches décoratives résistantes à l'usure et à la corrosion sur du laiton en une seule opération de revêtement sous vide.

30. Procédé selon l'une ou plusieurs des revendications 1, 17, 25 ou 26, caractérisé en ce que toutes les opérations du processus PVD s'effectuent dans une installation de revêtement multi-cibles qui est équipée de cibles correspondantes pour pouvoir réaliser des couches décoratives multicolores résistantes à l'usure et à la corrosion sur du laiton en une seule opération de revêtement sous vide.

31. Procédé selon les revendications 1 et 17, caractérisé en ce que le processus d'attaque avec des ions de métal commence déjà à une température du substrat de 120°C, et en ce qu'une température du substrat de 200°C n'est pas dépassée.

32. Procédé selon la revendication 1, caractérisé en ce que le revêtement avec du cuivre ou avec un alliage de cuivre ou avec du niobium ou du tantale est effectué dans une plage de température de 200 à 250°C.

33. Procédé selon les revendications 1 et 18, caractérisé en ce que lors du revêtement avec du TiN, ZrN, TiAlN, TiCN, ZrCN ou TiAlCN, la température de revêtement est dans la plage de 200 à 380°C.
